(19) **Europäisches Patentamt / European Patent Office / Office européen des brevets**

(11) **EP 3 057 238 B1**

(12) # FASCICULE DE BREVET EUROPEEN

(45) Date de publication et mention de la délivrance du brevet:
**08.11.2017 Bulletin 2017/45**

(51) Int Cl.:
*H03M 13/11* (2006.01)  *H03M 13/33* (2006.01)
*H04B 1/7183* (2011.01)

(21) Numéro de dépôt: **16154605.6**

(22) Date de dépôt: **08.02.2016**

(54) **MÉTHODE DE DÉCODAGE ITÉRATIF DE SÉQUENCES LFSR À FAIBLE PROBABILITÉ DE FAUSSE ALARME**

**ITERATIVE DEKODIERUNG VON LFSR-SEQUENZEN MIT GERINGER WAHRSCHEINLICHKEIT EINES FEHLALARMS**

**METHOD FOR ITERATIVE DECODING OF LFSR SEQUENCES WITH LOW PROBABILITY OF FALSE ALARM**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.02.2015 FR 1551116**

(43) Date de publication de la demande:
**17.08.2016 Bulletin 2016/33**

(73) Titulaire: **Commissariat à l'Énergie Atomique et aux Énergies Alternatives 75015 Paris (FR)**

(72) Inventeur: **BOUVIER DES NOES, Mathieu 38000 GRENOBLE (FR)**

(74) Mandataire: **Brevalex 56, Boulevard de l'Embouchure B.P. 27519 31075 Toulouse Cedex 2 (FR)**

(56) Documents cités:
EP-A1- 1 524 771     US-A1- 2002 116 677

- **FABIO PRINCIPE ET AL: "Rapid Acquisition of Gold Codes and Related Sequences Using Iterative Message Passing on Redundant Graphical Models", PROC. MILCOM 2006, 1 octobre 2006 (2006-10-01), pages 1-7, XP055189450, DOI: 10.1109/MILCOM.2006.302342**
- **DES NOES MATHIEU ET AL: "Improving the decoding of m-sequences by exploiting their decimation property", PROC. 21ST EUROPEAN SIGNAL PROCESSING CONFERENCE (EUSIPCO 2013), 9 septembre 2013 (2013-09-09), pages 1-5, XP032593879,**
- **DES NOES MATHIEU ET AL: "Blind identification of the uplink scrambling code index of a WCDMA transmission and application to femtocell networks", PROC. 2013 IEEE INTERNATIONAL CONFERENCE ON COMMUNICATIONS (ICC), 9 juin 2013 (2013-06-09), pages 4530-4535, XP032522837, ISSN: 1550-3607, DOI: 10.1109/ICC.2013.6655282 [extrait le 2013-11-04]**
- **HEHN T ET AL: "Multiple-bases belief-propagation decoding of high-density cyclic codes", IEEE TRANSACTIONS ON COMMUNICATIONS, IEEE SERVICE CENTER, PISCATAWAY, NJ. USA, vol. 58, no. 1, 1 janvier 2010 (2010-01-01), pages 1-8, XP011300484, ISSN: 0090-6778, DOI: 10.1109/TCOMM.2010.01.070468**
- **HALFORD T R ET AL: "Transactions Letters -Random Redundant Iterative Soft-in Soft-out Decoding", IEEE TRANSACTIONS ON COMMUNICATIONS, IEEE SERVICE CENTER, PISCATAWAY, NJ. USA, vol. 56, no. 4, 1 avril 2008 (2008-04-01), pages 513-517, XP011226250, ISSN: 0090-6778, DOI: 10.1109/TCOMM.2008.060105**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

La présente invention concerne de manière générale le domaine du décodage itératif par passage de messages, et plus particulièrement celui de séquences de longueur maximale.

**ÉTAT DE LA TECHNIQUE ANTÉRIEURE**

Les séquences de longueur maximale, encore dénommées M-séquences, sont des séquences binaires présentant de très bonnes propriétés de corrélation. Elles sont pour cette raison largement utilisées dans la synchronisation des récepteurs de systèmes de télécommunication sans fil ou de systèmes de positionnement.

Une méthode classique de synchronisation d'un récepteur au moyen d'une M-séquence consiste à effectuer une corrélation du signal reçu avec une réplique de la M-séquence. Si un pic de corrélation est observé et si son amplitude est supérieure à un niveau de seuil prédéterminé, le récepteur est synchronisé sur le pic en question.

On rappelle qu'une M-séquence est obtenue à partir d'un polynôme générateur primitif. Si ce polynôme est de degré r, la période de la séquence est maximale, soit de longueur $2^r$ -1. En pratique, une M-séquence peut être générée à partir d'un registre à décalage rebouclé sur lui-même, encore dénommé LFSR (*Linear Feedback Shift Register*), les prises du registre correspondant aux coefficients du polynôme générateur.

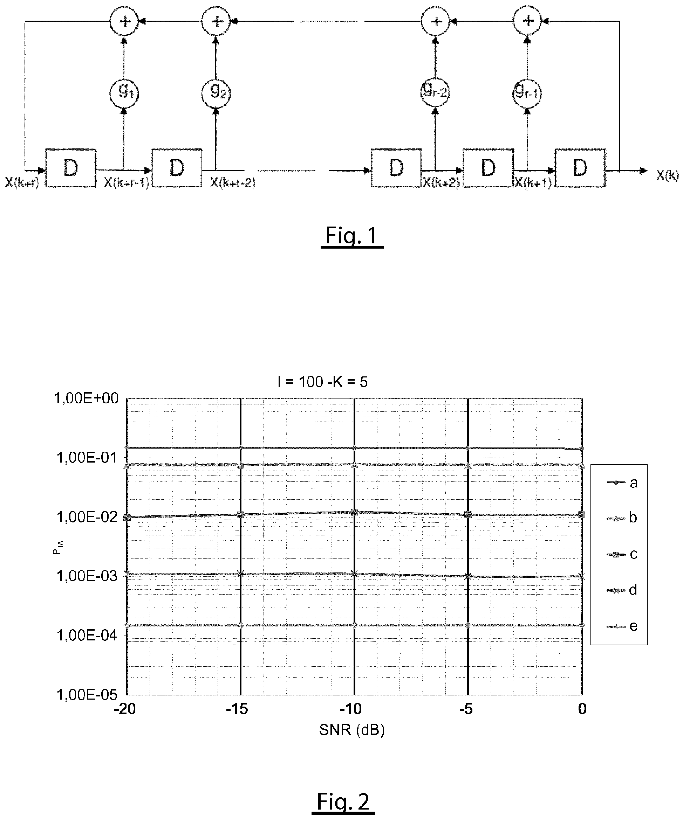

La Fig. 1 représente un exemple de générateur de M-séquence utilisant un registre LFSR, selon une structure dite de Fibonacci.

Le polynôme générateur (primitif) servant à générer la M-séquence est ici :

$$g(x) = \sum_{k=0}^{r} g_k x^k \qquad (1)$$

Le générateur est initialisé par un mot de r bits qui est stocké dans le registre à décalage. Le code ainsi généré, dit code simplexe, est un code cyclique [*N,r*] où $N = 2^r$ -1 est la taille du mot de code et *r* le nombre de bits d'information.

Le polynôme de vérification (*check polynomial*), encore dénommé polynôme de parité, associé au polynôme générateur $g(x)$ est $h(x) = (x^N-1)/g(x)$. On peut montrer que pour le code simplexe $h(x)=x^r g(x^{-1})$ et que la matrice de parité associée à ce code est la matrice **H** de taille $(N-r) \times N$ donnée par :

$$\mathbf{H} = \begin{bmatrix} g_r & \cdots & g_0 & 0 & \cdots & \cdots & 0 \\ 0 & g_r & \cdots & g_0 & 0 & \cdots & 0 \\ \vdots & \ddots & \ddots & \ddots & \ddots & \ddots & \vdots \\ 0 & \cdots & 0 & g_r & \cdots & g_0 & 0 \\ 0 & \cdots & \cdots & 0 & g_r & \cdots & g_0 \end{bmatrix} \qquad (2)$$

Une méthode alternative de décodage consiste à considérer les éléments de la M-séquence comme des noeuds de variables et les équations de parité auxquelles ceux-ci doivent satisfaire, comme des noeuds de contraintes. Il est alors possible d'effectuer un décodage itératif à passage de messages dans un graphe bipartite formé par les noeuds de variables et les noeuds de contraintes, les arêtes entre noeuds de variables et noeuds de contraintes étant donnés par les éléments de la matrice de parité. On trouvera par exemple un décodage itératif de M-séquence par passage de messages dans l'article de O.W. Yeung et al. intitulé « An iterative algorithm and low complexity hardware architecture for fast acquisition of long PN codes in UWB systems » publié dans Journal of VLSI Signal Processing 43, pp. 25-42, 2006.

En pratique, un décodage itératif de M-séquence à passage de messages converge lentement si l'on utilise un graphe bipartite basé sur la matrice de parité donnée par expression (2). Pour remédier à cette difficulté, il a été proposé dans l'article précité de combiner une pluralité de sous-graphes élémentaires, chaque sous-graphe élémentaire correspondant à un ensemble de nouvelles équations de parité. Plus précisément, les noeuds de variables restent identiques et l'on introduit des noeuds de contraintes redondants. En effet, la somme d'une pluralité d'équations de parité (par exemple celles correspondant aux lignes de la matrice **H**) est encore une équation de parité.

On aboutit alors à un graphe constitué de plusieurs sous-graphes élémentaires bipartites, ces différents sous-graphes élémentaires partageant l'ensemble des noeuds de variables et chaque sous-graphe élémentaire comprenant ses noeuds de contraintes spécifiques. En d'autres termes, cela revient à utiliser une matrice de parité étendue, $\mathbf{H}_{ext}$

obtenue par concaténation de $K$ matrices de parité élémentaires :

$$\mathbf{H}_{ext} = \begin{bmatrix} \mathbf{H}_0 \\ \mathbf{H}_1 \\ \vdots \\ \mathbf{H}_{K-1} \end{bmatrix} \tag{3}$$

Les matrices de parité élémentaires $\mathbf{H}_a$ étant des matrices de Toeplitz circulantes, de taille $(N\text{-}r_a)\times N$ définies par:

$$\mathbf{H}_a = \begin{bmatrix} c_{a,0} & \cdots & \cdots & c_{a,r_a} & 0 & \cdots & \cdots & & 0 \\ 0 & c_{a,0} & \cdots & \cdots & c_{a,r_a} & 0 & \cdots & & 0 \\ \vdots & \ddots & \ddots & \ddots & \ddots & \ddots & \ddots & & \vdots \\ \vdots & \ddots & \ddots & \ddots & \ddots & \ddots & \ddots & & 0 \\ 0 & \cdots & \cdots & 0 & c_{a,0} & \cdots & \cdots & & c_{a,r_a} \\ c_{a,r_a} & \cdots & \cdots & \cdots & 0 & c_{a,0} & \cdots & & c_{a,r_a-1} \\ \vdots & \ddots & \cdots & \cdots & 0 & \ddots & \ddots & & \vdots \\ c_{a,1} & \cdots & c_{a,r_a} & 0 & \cdots & \cdots & 0 & & c_{a,0} \end{bmatrix} \tag{4}$$

Chaque matrice élémentaire $\mathbf{H}_a$ représente la convolution de la séquence d'échantillons reçus avec un polynôme de parité $h_a(x)=1+x^{i_a}+...+x^{r_a}$ de degré $r_a$ et chaque ligne de cette matrice correspond à une équation de parité basée sur ce polynôme.

La synchronisation du récepteur consiste à déterminer si une suite de $M$ échantillons reçus, $\mathbf{y}=(y_0...y_{M-1})$ correspond à une portion de séquence LFSR, autrement de déterminer si cette suite d'échantillons peut être décodée par le décodeur à passage de messages. Si c'est bien le cas, le récepteur peut en déduire le début de la séquence (le mot initial dans le registre LFSR) et l'endroit où se trouve la suite d'échantillons dans la séquence.

Le récepteur doit par conséquent faire le choix entre deux hypothèses :

$$A_0 : y_k = w_k \tag{5-1}$$

$$A_1 : y_k = s_k + w_k \tag{5-2}$$

où $s_k$ sont les éléments de la séquence LFSR et $w_k$ sont des échantillons de bruit.

Si le récepteur détermine qu'il a détecté une séquence LFSR (hypothèse $A_1$) alors que les échantillons reçus sont en réalité du bruit (hypothèse $A_0$ valide), on a une situation de fausse alarme.

On suppose ici pour simplifier que le récepteur observe une suite de $M = N$ échantillons consécutifs, autrement dit un nombre d'échantillons correspondant à la longueur d'une séquence LFSR.

Pour faire le choix entre les hypothèses $A_0$ et $A_1$, le décodeur effectue un décodage itératif à passage de messages de la suite d'échantillons, les noeuds de variables étant initialisés au moyen de ces échantillons.

Le décodage à passage de messages peut être effectué de manière connue au moyen d'un algorithme de type Sum-product tel que décrit dans l'article de Kschichang et al. intitulé « Factor graph and the sum-product algorithm » publié dans IEEE Trans. on Information Theory, vol. 47, no. 2, Feb. 2001 ou bien d'un algorithme de type Min-Sum tel que décrit dans la thèse de N. Wiberg intitulée « Codes and decoding on general graphs », University of Linköping, Sweden, 1996.

Le récepteur détermine que l'hypothèse $A_1$ est satisfaite si :

$$\mathbf{H}_{ext}\mathbf{y}^T = 0 \qquad\qquad\qquad (6)$$

où $\mathbf{H}_{ext}$ est définie par les expressions (3) et (4). Autrement dit, le récepteur vérifie que toutes les équations de parité sont satisfaites.

On a pu constater que le choix des polynômes $h_a(x)$ pouvait fortement influencer la probabilité de fausse alarme ($P_{FA}$) du récepteur.

La Fig. 2 montre par exemple la probabilité de fausse alarme pour un récepteur décodant une séquence LFSR générée à partir d'un polynôme générateur dont les coefficients sont définis en numérotation octale par le mot 2415.

Pour le décodage, on a choisi une matrice de parité étendue, $\mathbf{H}_{ext}$, constituée par la concaténation de $K$=5 matrices de parité élémentaires $\mathbf{H}_a$, chaque matrice $\mathbf{H}_a$ correspondant à un polynôme $h_a(x)$ de poids 3. On rappelle que le poids d'un polynôme est le nombre de ses monômes non nuls.

On a représenté sur la figure la probabilité de fausse alarme ($P_{FA}$) en fonction du rapport signal sur bruit en réception (*SNR*), ce pour différentes combinaisons de $K$=5 matrices $\mathbf{H}_a$. Les différentes combinaisons, et donc les différentes matrices $\mathbf{H}_{ext}$ sont désignées par *a,b,c,d,e*.

On remarque que le taux de fausse alarme varie de trois ordres de grandeurs selon la combinaison de polynômes sélectionnée.

L'article de F. Principe et al. intitulé « Rapid acquisition of Gold codes and related sequences using iterative message passing on redundant graphical models », publié dans Proc. Milcom 2006, 1.10.2006, pages 1-7 décrit une méthode d'acquisition rapide de M-séquences au moyen d'un décodage itératif par passage de messages dans un graphe bipartite

L'article de M. Des Noes et al. intitulé « Improving the decoding of M-sequences by exploiting their decimation property », publié dans Proc. EUSIPCO 2013, 9.9.2013, pages 1-5 décrit une méthode de décodage de M-séquences utilisant les propriétés de décimation de ces séquences.

L'article de M. Des Noes et al. intitulé « Blind identification of the uplink scrambling code index of a WCDMA transmission and application to femtocell networks », publié dans Proc. IEEE ICC 2013, 9.6.2013, pages 4530-4535 décrit une méthode de détermination de l'indice d'un code de brouillage pour la liaison montante d'un système WCDMA.

La demande de brevet US-A-2002/0116677 concerne une méthode de décodage itératif d'un code binaire cyclique.

Le but de la présente invention est de proposer une méthode de décodage de séquence LFSR (ou M-séquence) présentant un très faible taux de fausse alarme ($P_{FA}$) sans sacrifier la vitesse de convergence.

**EXPOSÉ DE L'INVENTION**

La présente invention est définie par une méthode de décodage itératif à passage de messages d'une séquence LFSR de longueur *N* générée au moyen d'un polynôme générateur, ladite séquence LFSR étant associée, comme code simplexe, à une matrice de parité, **H,** ladite méthode de décodage comprenant les étapes suivantes :

(a) détermination d'un ensemble de polynômes de parité, de poids égal à 3 et de constante égale à 1, correspondant à une combinaison d'équations de parité de la matrice **H** ;
(b) génération d'une matrice de parité étendue $\mathbf{H}_{ext}$ par concaténation d'un nombre prédéterminé $K$ de matrices de parité élémentaires, respectivement associées à $K$ polynômes de parité sélectionnés dans ledit ensemble ;
(c) vérification que le graphe de Tanner associé à la matrice $\mathbf{H}_{ext}$ ne comporte pas de cycle de longueur 4 et, en absence de tel cycle,
(d) calcul du nombre de cycles de longueur 6 au sein du graphe de Tanner et, dans le cas où ce nombre est égal à *NK,* stockage dans une table de la combinaison des polynômes de parité sélectionnés à l'étape (b) ;

les étapes (b), (c), (d) étant répétées pour toutes les combinaisons de $K$ polynômes de parité dudit ensemble ; et

(e) calcul pour chaque combinaison de polynômes de parité stockée dans ladite table du nombre de cycles de longueur 8 dans le graphe de Tanner associé à la matrice $\mathbf{H}_{ext}$;
(f) sélection d'une combinaison de $K$ polynômes de parité correspondant au plus faible nombre de cycles de longueur 8 calculé à l'étape (e) pour effectuer un décodage itératif à passage de messages de ladite séquence dans le graphe de Tanner associé à la matrice $\mathbf{H}_{ext}$ générée à partir de la combinaison ainsi sélectionnée.

La vérification à l'étape (c) consiste avantageusement à déterminer si l'une des conditions suivantes $r_b - i_b = i_a$, $r_b - i_b = r_a$, $r_b - i_b = r_a - i_a$ ; $r_a - i_a = i_b$ est satisfaite pour au moins un couple quelconque de polynômes de parité $g_a(x)$

= 1 + $x^{ia}$ + $x^{ra}$ et $g_b(x)$ =1+$x^{ib}$+$x^{rb}$, parmi les $K$ polynômes de parité sélectionnés à l'étape (b), l'absence d'un cycle de longueur 4 dans le graphe de Tanner étant établie si aucune des conditions précédentes n'est satisfaite.

Le nombre de cycles de longueur 6 dans le graphe de Tanner associé à la matrice $\mathbf{H}_{ext}$ peut être obtenu à partir de $N_6 = \frac{1}{6}\left(tr(\mathbf{A}^3) - 3KN\left(\left(K^2 + 3K + 1\right) - 9\left(K+1\right) + 2\right)\right)$ où $\mathbf{A} = \mathbf{H}_{ext}\mathbf{H}_{ext}^T$ et $tr(.)$ est la fonction trace.

Le calcul du nombre de cycles de longueur 8 dans le graphe de Tanner associé à la matrice $\mathbf{H}_{ext}$ comprend le calcul de $tr(\mathbf{A}^4)$-4(3$K$+1)$tr(\mathbf{A}^3)$ où $\mathbf{A} = \mathbf{H}_{ext}\mathbf{H}_{ext}^T$ et $tr(.)$ est la fonction trace.

La trace $tr(\mathbf{A}^3)$ peut être obtenue par $tr(\mathbf{A}^3) = \sum_{i=0}^{K-1}\sum_{j=0}^{K-1}\sum_{k=0}^{K-1} T_{ijk}$ où

$$T_{ijk} = \sum_{\alpha \in \Omega_{ji}} \sum_{\beta \in \Omega_{kj}} A_{k,i}(0,\gamma)A_{k,j}(0,\beta)A_{j,i}(0,\alpha),$$

$A_{i,j}(\mu,v)$ étant l'élément à la ligne $\mu$ et la colonne $v$ de la matrice $\mathbf{A}_{i,j} = \mathbf{H}_i\mathbf{H}_j^T$, où $\mathbf{H}_i$ et $\mathbf{H}_j$ sont les matrices de parité élémentaires associées à deux polynômes de parité parmi les $K$ polynômes de parité sélectionnés à l'étape (b), $\alpha=\varphi(s-\ell)$; $\beta=\varphi(h-\ell)$; $\gamma=\varphi(s-h)$ où :

$$\varphi(u) = \begin{cases} u \text{ si } 0 \leq u \leq N-1 \\ N+u \text{ si } -N < u < 0 \end{cases}$$

et où $\Omega_{ji}$, $\Omega_{kj}$ sont respectivement les ensembles d'éléments non nuls de la première ligne de la matrice $\mathbf{A}_{i,j}$ et de première ligne de la matrice $\mathbf{A}_{j,k}$.

La trace $tr(\mathbf{A}^4)$ est obtenue en calculant $tr(\mathbf{A}^4) = \sum_{i=0}^{K-1}\sum_{j=0}^{K-1}\sum_{k=0}^{K-1}\sum_{\ell=0}^{K-1} T_{ijk\ell}$ où :

$$T_{ijk\ell} = \sum_{\alpha \in \Omega_{ji}} \sum_{\beta \in \Omega_{kj}} \sum_{\gamma \in \Omega_{\ell k}} A_{\ell,i}\left(0,(\alpha+\beta+\gamma \bmod N)\right)A_{k,j}(0,\beta)A_{j,i}(0,\alpha)A_{\ell,k}(0,\gamma)$$

$A_{i,j}(\mu,v)$ étant l'élément à la ligne $\mu$ et la colonne $v$ de la matrice $\mathbf{A}_{i,j} = \mathbf{H}_i\mathbf{H}_j^T$, où $\mathbf{H}_i$ et $\mathbf{H}_j$ sont les matrices de parité élémentaires associées à deux polynômes de parité parmi les $K$ polynômes de parité sélectionnés à l'étape (b), $a = \varphi(s-\ell)$ ; $\beta = \varphi(h-\ell)$ ; $\gamma=\varphi(s-h)$ où :

$$\varphi(u) = \begin{cases} u \text{ si } 0 \leq u \leq N-1 \\ N+u \text{ si } -N < u < 0 \end{cases}$$

et où $\Omega_{ji}$, $\Omega_{kj}$, $\Omega_{\ell k}$ sont les ensembles d'éléments non nuls des premières lignes respectives des matrices $\mathbf{A}_{i,j}$, $\mathbf{A}_{j,k}$, $\mathbf{A}_{k,\ell}$

Le décodage itératif utilise avantageusement un algorithme de type Min-Sum sur le graphe de Tanner associé à la matrice $\mathbf{H}_{ext}$ générée à partir de la combinaison sélectionnée à l'étape (e).

Alternativement, le décidage itératif utilise un algorithme de type Sum-Product sur le graphe de Tanner associé à la matrice $\mathbf{H}_{ext}$ générée à partir de la combinaison sélectionnée à l'étape(e).

Dans tous les cas, on peut appliquer un critère de convergence aux valeurs des noeuds de variables du graphe de Tanner après un nombre prédéterminée d'itérations et si ce critère n'est pas satisfait, on conclut à une absence de la séquence LFSR.

**BRÈVE DESCRIPTION DES DESSINS**

D'autres caractéristiques et avantages de l'invention apparaîtront à la lecture de modes de réalisation préférentiels de réalisation en référence aux figures jointes parmi lesquelles :

La Fig. 1 représente un générateur de M-séquence selon une représentation de Fibonacci ;

La Fig. 2 représente le taux de fausse alarme d'un récepteur, pour une séquence LFSR donnée et différentes matrices de parité ;

La Fig. 3 représente un cycle de longueur 6 dans un graphe bipartite utilisé par le décodeur;

La Fig. 4 représente de manière schématique un organigramme de la méthode de décodage selon un mode de réalisation de l'invention.

## EXPOSÉ DÉTAILLÉ DE MODES DE RÉALISATION PARTICULIERS

On considèrera dans la suite un récepteur devant se synchroniser à l'aide d'une séquence LFSR et plus précisément un décodeur devant décider entre une hypothèse de présence ($A_1$) et une hypothèse d'absence ($A_0$) d'une telle séquence, comme décrit dans la partie introductive.

Le décodeur fait appel à une méthode de décodage à passage de messages dans un graphe bipartite. Le graphe bipartite est constitué d'une pluralité de noeuds de variable représentant les éléments de la séquence et d'une pluralité de noeuds de contraintes représentant des équations de parité à vérifier par les éléments de la séquence. Le graphe est constitué d'une pluralité $K$ de sous-graphes élémentaires, lesdits sous-graphes élémentaires partageant les noeuds de variables, chaque sous-graphe élémentaire comprenant ses noeuds de contraintes propres. Les arêtes de chaque sous-graphe élémentaire sont données par les lignes d'une matrice de parité élémentaire, $\mathbf{H}_a$ obtenue par combinaison des lignes de la matrice de parité $\mathbf{H}$, chaque matrice de parité élémentaire correspondant à un polynôme de parité (ou polynôme de vérification) $h_a(x)$.

La matrice de parité étendue $\mathbf{H}_{ext}$ associée au graphe est alors la concaténation des matrices de parité élémentaires $\mathbf{H}_a$. Le décodage itératif à passage de messages est réalisé au moyen d'un algorithme de type Sum-product ou Min-sum comme indiqué plus haut.

Etant donné que la combinaison de deux lignes de la matrice de parité $\mathbf{H}$ fournit encore une équation de parité, il existe, pour un entier $K$ donné, un grand nombre de combinaisons possibles de polynômes de parité. Pour un polynôme générateur donné $g(x)$ (et donc une matrice de parité $\mathbf{H}$ donnée), les combinaisons possibles de polynômes de parité peuvent être obtenues, de manière connue en soi, selon la méthode décrite dans les articles de W.T. Penzhorn et al. intitulé « Computation of low-weight parity checks for correlation attacks on stream ciphers », Cryptography and Coding, Springer, 1995 et de P. Chose et al. intitulé « Fast correlation attacks: an algorithmic point of view », Advances in Cryptology, Eurocrypt 2002, Springer 2002, incorporés ici par référence.

L'idée à la base de l'invention est de ne faire appel qu'à des polynômes de parité $h_a(x)$ de poids $t$=3 et de constante égale à 1, d'effectuer ensuite parmi ceux-ci une sélection pour éliminer les cycles de longueur 4 et enfin de choisir parmi les restants ceux qui permettent de minimiser le nombre de cycles de longueurs 6 et 8 dans le graphe bipartite (ou graphe de Tanner).

On a pu notamment montrer par simulation, à l'encontre d'une idée communément admise, que la réduction du nombre de cycles de longueur 6 dans le graphe de Tanner ne permettait pas de réduire la probabilité de décodage erroné mais réduisait sensiblement le taux de fausse alarme. De même, on a pu montrer que la réduction du nombre de cycles de longueur 8 réduisait encore davantage le taux de fausse alarme.

Les cycles d'un graphe bipartite sont nécessairement de longueur paire (le nombre d'arêtes d'un cycle est nécessairement pair). Les cycles de plus courts dans un tel graphe sont donc des cycles de longueurs 4, 6, 8.

Un cycle de longueur 4 se traduit dans le graphe de Tanner par deux noeuds de variables tout deux connectés à deux mêmes noeuds de contrainte (circuit en forme de papillon entre deux noeuds de variables et deux noeuds de contraintes) et dans la matrice de parité étendue $\mathbf{H}_{ext}$ par des éléments égales à 1 aux sommets d'un rectangle.

Les polynômes de poids 3, respectivement associés aux matrices $\mathbf{H}_a$ et $\mathbf{H}_b$, sont notés $g_a(x)=1+x^{i_a}+x^{r_a}$ et $g_b(x)=1+x^{i_b}+x^{r_b}$ où $r_a$ et $r_b$ sont les degrés des polynômes $g_a(x)$ et $g_b(x)$.

Si l'on suppose que $r_a \geq r_b$, on peut voir qu'en raison de la structure de Toeplitz des matrices $\mathbf{H}_a$ et $\mathbf{H}_b$, qu'un cycle de longueur 4 dans le graphe bipartite (associé à la matrice de parité étendue $\mathbf{H}_{ext}$) ne peut exister que si et seulement si l'une des conditions suivantes est satisfaite :

$$r_b - i_b = i_a \qquad\qquad (7\text{-}1)$$

$$r_b - i_b = r_a \qquad\qquad (7\text{-}2)$$

$$r_b - i_b = r_a - i_a \qquad\qquad (7\text{-}3)$$

$$r_a - i_a = i_b \tag{7-4}$$

Autrement dit, pour exclure les cycles de longueur 4, il suffit de choisir une combinaison de polynômes générateurs telle que, pour deux polynômes quelconques $g_a(x)$, $g_b(x)$ appartenant à cette combinaison, aucune des conditions (7-1) à (7-4) n'est vérifiée.

Le nombre de cycles de longueur 6 dans le graphe de Tanner peut être obtenu en utilisant la méthode générale décrite dans l'article de T. R. Halford et al. intitulé « An algorithm for counting short cycles in bipartite graphs », publié dans IEEE Trans. on Information Theory, vol. 52, no. 1, janvier 2006, pp. 287-292.

Plus précisément, on définit les opérateurs suivants :

$$\mathbf{Y} = \mathbf{X} - \lambda = \left[ y(i, j) \right] \quad \text{où} \quad y(i, j) = x(i, j) - \lambda \tag{8-1}$$

$$\mathbf{U} = \max(\mathbf{X}, 0) = \left[ u(i, j) \right] \quad \text{où} \quad u(i, j) = \max(0, x(i, j)) \tag{8-2}$$

$$\mathbf{V} = \mathbf{X} \circ \mathbf{Y} = \left[ v(i, j) \right] \quad \text{où} \quad v(i, j) = x(i, j) y(i, j) \tag{8-3}$$

$$Z(\mathbf{X}) = \mathbf{X} - \mathbf{X} \circ \mathbf{I} \tag{8-4}$$

On comprend donc que l'opérateur $\circ$ représente la multiplication d'Hadamard et que l'opérateur Z(.) annule la diagonale de la matrice à laquelle il s'applique.

On définit en outre les matrices suivantes :

$$\mathbf{A} = \mathbf{H}_{ext} \mathbf{H}_{ext}^T \tag{9-1}$$

$$\mathbf{B} = \mathbf{H}_{ext}^T \mathbf{H}_{ext} \tag{9-2}$$

$$\tilde{\mathbf{A}} = \mathbf{A} \circ \mathbf{I} \tag{9-3}$$

$$\tilde{\mathbf{B}} = \mathbf{B} \circ \mathbf{I} \tag{9-4}$$

$$\tilde{\mathbf{A}}_m = \max\left( \tilde{\mathbf{A}} - 1, 0 \right) \tag{9-5}$$

$$\tilde{\mathbf{B}}_m = \max\left( \tilde{\mathbf{B}} - 1, 0 \right) \tag{9-6}$$

On peut montrer que le nombre de cycles de longueur 6 est égal à :

$$N_6 = \frac{1}{6} tr(\mathbf{L}) \tag{10-1}$$

avec

$$\mathbf{L} = Z(\mathbf{A})\mathbf{A}^2 - \mathbf{E}\tilde{\mathbf{B}}_m \mathbf{B}\mathbf{E}^T - Z(\mathbf{A}\tilde{\mathbf{A}}_m)\mathbf{A} - \mathbf{E}Z(\mathbf{B}\tilde{\mathbf{B}}_m)\mathbf{E}^T + \tilde{\mathbf{A}}_m \mathbf{E}\tilde{\mathbf{B}}_m \mathbf{E}^T$$

$$\tag{10-2}$$

Les matrices **A** et **B** dépendent de la matrice de parité étendue $\mathbf{H}_{ext}$ et par conséquent de la combinaison de polynômes de parité sélectionnée. On rappelle que la matrice de parité étendue est formée par concaténation de $K$ matrices de parité élémentaires $\mathbf{H}_{ext} = \left[ \mathbf{H}_{a(1)}^T \mathbf{H}_{a(2)}^T ... \mathbf{H}_{a(K)}^T \right]^T$ où $g_{a(k)}(x) = 1 + x^{i_{a(k)}} + x^{r_{a(k)}}$ est le polynôme de parité associé à la matrice de parité $\mathbf{H}_{a(k)}$, la combinaison de polynômes de parité étant formée par les polynômes $g_{a(k)}(x)$, $k$ =1,..., $K$.

Du fait que les matrices de parité élémentaires $\mathbf{H}_{a(k)}$ sont circulantes, on peut montrer que l'expression (10-2) peut se simplifier en :

$$N_6 = \frac{1}{6}\left( tr(\mathbf{A}^3) - 3KN\left( \left( K^2 + 3K + 1 \right) - 9\left( K + 1 \right) + 2 \right) \right) \qquad (11)$$

Autrement dit, étant donné que $K$ et $N$ sont des constantes, minimiser le nombre de cycles de longueur 6 dans le graphe de Tanner revient à minimiser la trace de la matrice $\mathbf{A}^3$.

Par ailleurs, il est possible de déterminer le nombre minimal de cycles de longueur 6. En effet, on peut montrer que 3 cycles de longueur 6 passent par chaque noeud de variable.

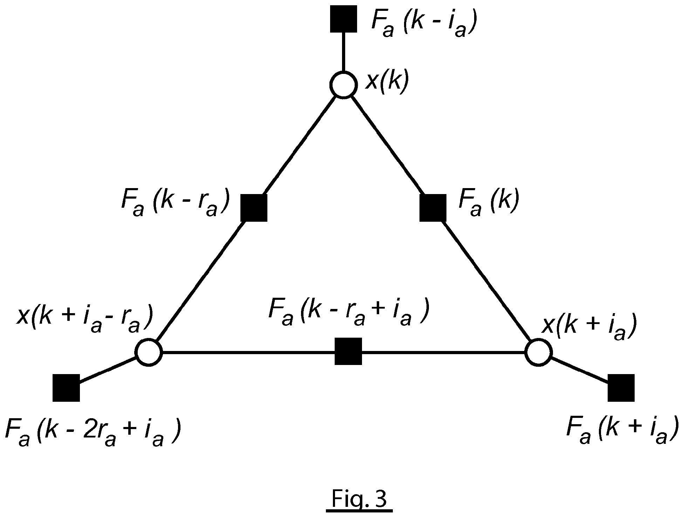

La Fig. 3 montre un cycle de longueur 6 passant par les noeuds de variables $z(k)$, $z(k+i_a)$, $z(k+i_a-r_a)$ et les noeuds de contraintes $F_a(k), F_a(k-r_a), F_a(k-r_a+i_a)$ (représentant chacun une équation de parité de la matrice $\mathbf{H}_a$). Les 2 autres cycles se déduisent de celui représenté en remplaçant $k$ par $k-i_a$ et $k + r_a-i_a$. Etant donné que chaque cycle met en jeu 3 noeuds de variables, le nombre minimum de cycles de longueur 6 est :

$$N_6^{\min} = NK \qquad (12)$$

De la même façon que précédemment, on peut calculer le nombre de cycles de longueur 8 dans le graphe de Tanner pour chaque matrice de parité étendue $\mathbf{H}_{ext} = \left[ \mathbf{H}_{a(1)}^T \mathbf{H}_{a(2)}^T ... \mathbf{H}_{a(K)}^T \right]^T$, correspondant à une combinaison donnée de polynômes de parité $g_{a(k)}(x)$, $k$=1, ..., $K$ :

$$N_8 = \frac{1}{8}\left( tr\left( \mathbf{A}^4 \right) - 4(3K+1) tr\left( \mathbf{A}^3 \right) + Q(N,K) \right) \qquad (13)$$

où $Q(N,K)$ est une valeur qui ne dépend que des constantes $K, N$. On comprend donc que la minimisation du nombre de cycles de longueur 8 revient à minimiser $tr(\mathbf{A}^4) - 4(3K+1) tr(\mathbf{A}^3)$ sur l'ensemble des combinaisons possibles $g_{a(k)}(x)$, $k$=1,..., $K$.

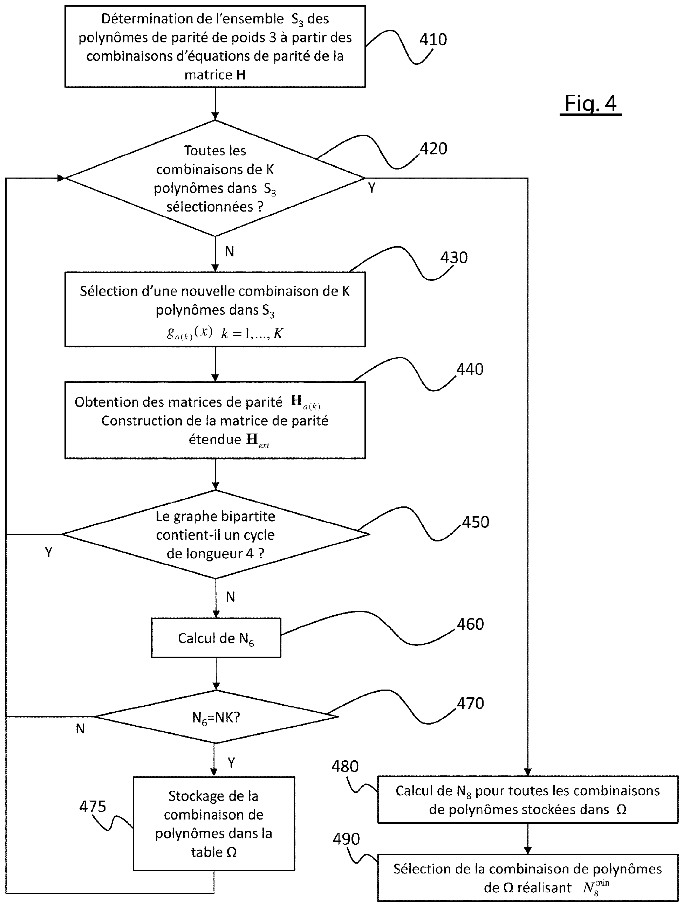

La Fig. 4 représente un organigramme de la méthode de décodage selon un mode de réalisation de l'invention.

On part du principe que le récepteur connait le polynôme générateur de la M-séquence ou, de manière équivalente, la matrice de parité **H** de cette séquence (matrice de parité de code simplexe).

La longueur $N$ de la séquence est supposée connue et l'on fixe un nombre $K$ de polynômes de parité, ou de manière équivalente, de matrices de parité élémentaires $\mathbf{H}_a$.

On supposera dans la suite, pour simplifier la présentation que le récepteur traite $N$ échantillons successifs. La méthode de décodage s'applique cependant également au cas où le récepteur ne reçoit que $M < N$ échantillons.

A l'étape 410, on détermine l'ensemble, $S_3$ des polynômes de parité et de poids 3 et de constante égale à 1, obtenus par combinaison des équations de parité de la matrice **H**.

Etant donné que le code simplexe $[2^r-1, r]$ est le dual du code de Hamming $[2^r-1, 2^r-r-1]$, le nombre $\Lambda_3$ d'équations (ou de polynômes) de parité de poids 3 et de constante égale à 1 est égal au nombre de mots du code de Hamming de poids 3 et de constante égale à 1, soit :

$$\Lambda_3 = 2^{r-1} - 1 \qquad (14)$$

A l'étape 420, on vérifie si toutes les combinaisons de $K$ polynômes de parité parmi l'ensemble $S_3$ ont déjà été sélectionnées. Dans l'affirmative, on passe à l'étape 480,

Si toutes les combinaisons de $K$ polynômes de parité parmi l'ensemble $S_3$ n'ont pas été sélectionnées, on sélectionne une nouvelle combinaison de $K$ polynômes à l'étape 430, $g_{a(k)}(x)$, $k$=1,..., $K$.

A l'étape 440, on déduit à partir des $K$ polynômes de parité ainsi sélectionnés, les matrices de parité correspondantes $\mathbf{H}_{a(k)}$, $k=1,...,$ $K$. Les éléments de ces matrices sont donnés par l'expression (4). On forme alors la matrice de parité étendue $\mathbf{H}_{ext} = \left[ \mathbf{H}_{a(1)}^{T} \mathbf{H}_{a(2)}^{T} ... \mathbf{H}_{a(K)}^{T} \right]^{T}$.

A l'étape 450, on vérifie que le graphe bipartite correspondant à la matrice de parité étendue $\mathbf{H}_{ext}$ ne comporte pas de cycle de longueur 4. Pour ce faire, on détermine si un couple quelconque de polynômes parmi les $K$ polynômes de parité sélectionnés satisfait l'une des conditions (7-1) à (7-4). Si c'est le cas on retourne à l'étape 420. A défaut on poursuit à l'étape 460.

On notera que les étapes 440 et 450 peuvent être interverties.

A l'étape 460, on calcule le nombre, $N_6$, de cycles de longueur 6 dans le graphe bipartite correspondant à la matrice de parité étendue $\mathbf{H}_{ext}$. Ce calcul peut être réalisé à partir de l'expression (11).

A l'étape 470, on vérifie si $N_6 = NK$. Si ce n'est pas le cas, on retourne directement à l'étape 420. En revanche, si c'est le cas, le graphe bipartite contient un nombre minimal de cycles de longueur 6 et la combinaison des polynômes $g_{a(k)}(x)$, $k=1,....$ $K$ est mémorisée dans une table $\Omega$ en 475, puis on retourne à l'étape 420 pour sélectionner une nouvelle combinaison de polynômes de $S_3$ (si elles n'ont pas déjà toutes sélectionnées).

A l'étape 480, on calcule pour chaque combinaison de polynômes stockée dans la table $\Omega$, le nombre $N_8$ de cycles de longueur 8 dans le graphe bipartite correspondant à la matrice de parité étendue $\mathbf{H}_{ext}$. A cet effet, on pourra se contenter de calculer la partie de $N_8$ qui dépend du choix de la combinaison, autrement dit tr($\mathbf{A}^4$)-4(3$K$+1)tr($\mathbf{A}^3$).

On retient en 490 la combinaison $C$ de polynômes de parité $g_{a(k)}(x)$, $k=1,...,K$ qui minimise $N_8$, autrement dit la combinaison :

$$C = \underset{\left\{ g_{a(k)}(x), k=1,..,K \right\} \in \Omega}{\arg\min} (N_8) \tag{15}$$

La combinaison $C$ des polynômes ainsi retenue et le graphe bipartite associé à la matrice $\mathbf{H}_{ext}$ correspondante sont ensuite utilisés pour décoder la séquence des échantillons reçus.

Si, après un nombre prédéterminé d'itérations, un critère de convergence n'est pas rempli, le récepteur conclut à l'hypothèse $A_0$, à l'inverse, il conclut à l'hypothèse $A_1$. Le critère de convergence peut être par exemple une moyenne des valeurs absolues des noeuds de variables, exprimées sous la forme de logarithmes de rapport de vraisemblance ou LLR (*Log Likelihood Ratio*). Dans ce dernier cas, la moyenne des valeurs absolues peut être comparée à un seuil pour décider de l'hypothèse $A_0$ ou $A_1$.

Le calcul des nombres de cycles $N_6$ et $N_8$ peut toutefois être complexe en raison des termes tr($\mathbf{A}^3$) et tr($\mathbf{A}^4$), la taille de la matrice $\mathbf{A}$ pouvant atteindre 1000x1000.

Il est toutefois possible de simplifier le calcul des traces en question en tirant parti de la nature circulante des matrices de parité élémentaires $\mathbf{H}_a$.

Plus précisément, si l'on note $\mathbf{A}_{i,j} = \mathbf{H}_i \mathbf{H}_j^T$, la matrice $\mathbf{A}$ peut s'exprimer sous la forme :

$$\mathbf{A} = \begin{bmatrix} \mathbf{A}_{0,0} & \mathbf{A}_{0,1} & \cdots & \mathbf{A}_{0,N-1} \\ \mathbf{A}_{1,0} & \mathbf{A}_{1,1} & \cdots & \mathbf{A}_{1,N-1} \\ \vdots & \vdots & \ddots & \vdots \\ \mathbf{A}_{N-1,0} & \mathbf{A}_{N-1,1} & \cdots & \mathbf{A}_{N-1,N-1} \end{bmatrix} \tag{16}$$

Si l'on note $T_{ijk} = tr(\mathbf{A}_{i,j}\mathbf{A}_{k,j}\mathbf{A}_{i,k})$, la trace de $\mathbf{A}^3$ peut être obtenue de la manière suivante :

$$tr(\mathbf{A}^3) = \sum_{i=0}^{K-1} \sum_{j=0}^{K-1} \sum_{k=0}^{K-1} T_{ijk} \tag{17}$$

avec, en supposant $i \geq j \geq k$ :

$$T_{ijk} = \sum_{s=0}^{N-1} \sum_{h=0}^{N-1} \sum_{\ell=0}^{N-1} A_{ki}(0, \varphi(s-\ell)) A_{kj}(0, \varphi(h-\ell)) A_{ji}(0, \varphi(s-h)) \qquad (18)$$

où :

$$\varphi(u) = \begin{cases} u \text{ si } 0 \le u \le N-1 \\ N+u \text{ si } -N < u < 0 \end{cases} \qquad (19)$$

On peut alors montrer que :

$$T_{ijk} = \sum_{\alpha \in \Omega_{ji}} \sum_{\beta \in \Omega_{kj}} A_{k,i}(0, \gamma) A_{k,j}(0, \beta) A_{j,i}(0, \alpha) \qquad (20)$$

où $\alpha = \varphi(s\text{-}\ell)$; $\beta = \varphi(h\text{-}\ell)$; $\gamma = \varphi(s\text{-}h) = (\alpha + \beta) \bmod N$ et où $\Omega_{ji}$ est l'ensemble des éléments non nuls de la première ligne de la matrice $\mathbf{A}_{ij}$, soit $\Omega_{ji} = \{m | A_{j,i}(0,m) \neq 0\}$. On peut montrer que $\Omega_{ji}$ contient 9 indices si $i \neq j$ et 7 indices sinon. Le calcul de la trace de $\mathbf{A}^3$ à l'étape 460 est ainsi considérablement simplifié.

De manière similaire, si l'on note $T_{ijk\ell} = tr(\mathbf{A}_{i,j}\mathbf{A}_{k,j}\mathbf{A}_{i,k}\mathbf{A}_{\ell,k})$ le calcul de la trace de $\mathbf{A}^4$ l'étape 480 peut être simplifié à partir de :

$$tr(\mathbf{A}^4) = \sum_{i=0}^{K-1} \sum_{j=0}^{K-1} \sum_{k=0}^{K-1} \sum_{\ell=0}^{K-1} T_{ijk\ell} \qquad (21)$$

$$T_{ijk\ell} = \sum_{\alpha \in \Omega_{ji}} \sum_{\beta \in \Omega_{kj}} \sum_{\gamma \in \Omega_{\ell k}} A_{\ell,i}(0, (\alpha + \beta + \gamma \bmod N)) A_{k,j}(0, \beta) A_{j,i}(0, \alpha) A_{\ell,k}(0, \gamma)$$

$$(22)$$

avec les mêmes conventions de notation que précédemment.

Dans ce qui suit, nous avons supposé que la sélection des polynômes de parité, $g_{a(k)}(x)$, $k=1,...,K$ et la construction de la matrice de parité étendue correspondante $\mathbf{H}_{ext}$ était réalisée au niveau du récepteur. Toutefois, on comprendra que la sélection des polynômes de parité et la construction de la matrice de parité étendue pourra alternativement être réalisée une fois pour toutes, le cas échéant pour différents polynômes générateurs (autrement dit pour différentes M-séquences possibles) et les résultats de cette sélection/ construction stockés au niveau du récepteur.

## Revendications

1. Méthode de décodage itératif à passage de messages d'une séquence LFSR de longueur $N$ générée au moyen d'un polynôme générateur, ladite séquence LFSR étant associée, comme code simplexe, à une matrice de parité, **H**, ladite méthode de décodage comprenant les étapes suivantes :

    (a) détermination (410) d'un ensemble de polynômes de parité, de poids égal à 3 et de constante égale à 1, correspondant à une combinaison d'équations de parité de la matrice **H** ;
    (b) génération(440) d'une matrice de parité étendue $\mathbf{H}_{ext}$ par concaténation d'un nombre prédéterminé $K$ de matrices de parité élémentaires, respectivement associées à $K$ polynômes de parité sélectionnés dans ledit ensemble ;
    (c) vérification (450) que le graphe de Tanner associé à la matrice $\mathbf{H}_{ext}$ ne comporte pas de cycle de longueur 4 et, en absence de tel cycle,
    (d) calcul (460) du nombre de cycles de longueur 6 au sein du graphe de Tanner et, dans le cas où ce nombre est égal à $NK$, stockage dans une table (475) de la combinaison des polynômes de parité sélectionnés à l'étape (b) ;

les étapes (b), (c), (d) étant répétées pour toutes les combinaisons de K polynômes de parité dudit ensemble ; et

> (e) calcul (480) pour chaque combinaison de polynômes de parité stockée dans ladite table du nombre de cycles de longueur 8 dans le graphe de Tanner associé à la matrice $H_{ext}$;
> (f) sélection (490) d'une combinaison de $K$ polynômes de parité correspondant au plus faible nombre de cycles de longueur 8 calculé à l'étape (e) pour effectuer un décodage itératif à passage de messages de ladite séquence dans le graphe de Tanner associé à la matrice $H_{ext}$ générée à partir de la combinaison ainsi sélectionnée.

**2.** Méthode de décodage itératif selon la revendication 1, **caractérisée en ce que** la vérification à l'étape (c) consiste à déterminer si l'une des conditions suivantes $r_b - i_b = i_a$, $r_b - r_b = r_a$, $r_b - i_b = r_a - i_a$ ; $r_a - i_a = i_b$ est satisfaite pour au moins un couple quelconque de polynômes de parité $g_a(x) = 1 + x^{i_a} + x^{r_a}$ et $g_b(x) = 1 + x^{i_b} + x^{r_b}$, parmi les $K$ polynômes de parité sélectionnés à l'étape (b), l'absence d'un cycle de longueur 4 dans le graphe de Tanner étant établie si aucune des conditions précédentes n'est satisfaite.

**3.** Méthode de décodage itératif selon l'une des revendications précédentes, **caractérisée en ce que** le nombre de cycles de longueur 6 dans le graphe de Tanner associé à la matrice $H_{ext}$ est obtenu à partir de

$$N_6 = \frac{1}{6}\left(tr(\mathbf{A}^3) - 3KN\left(\left(K^2 + 3K + 1\right) - 9\left(K+1\right) + 2\right)\right) \text{ où } \mathbf{A} = \mathbf{H}_{ext}\mathbf{H}_{ext}^T \text{ et } tr(.) \text{ est la fonction trace.}$$

**4.** Méthode de décodage itératif selon l'une des revendications précédentes, **caractérisée en ce que** le calcul du nombre de cycles de longueur 8 dans le graphe de Tanner associé à la matrice $H_{ext}$ comprend le calcul de $tr(\mathbf{A}^4)$- $4(3K+1)tr(\mathbf{A}^3)$ où $\mathbf{A} = \mathbf{H}_{ext}\mathbf{H}_{ext}^T$ et $tr(.)$ est la fonction trace.

**5.** Méthode de décodage itératif selon la revendication 3 ou 4, **caractérisée en ce que** la trace $tr(\mathbf{A}^3)$ est obtenue en calculant $tr(\mathbf{A}^3) = \sum_{i=0}^{K-1}\sum_{j=0}^{K-1}\sum_{k=0}^{K-1} T_{ijk}$ où :

$$T_{ijk} = \sum_{\alpha \in \Omega_{ji}}\sum_{\beta \in \Omega_{kj}} A_{k,i}\left(0,\gamma\right) A_{k,j}\left(0,\beta\right) A_{j,i}\left(0,\alpha\right)$$

$A_{i,j}(\mu,v)$ étant l'élément à la ligne $\mu$ et la colonne $v$ de la matrice $\mathbf{A}_{i,j} = \mathbf{H}_i\mathbf{H}_j^T$, où $H_i$ et $H_j$ sont les matrices de parité élémentaires associées à deux polynômes de parité parmi les $K$ polynômes de parité sélectionnés à l'étape (b), où $\Omega_{ji}$, $\Omega_{kj}$ sont respectivement les ensembles d'éléments non nuls de la première ligne de la matrice $\mathbf{A}_{i,j}$ et de première ligne de la matrice $\mathbf{A}_{j,k}$, et où $\gamma = (\alpha + \beta)mod.N$.

**6.** Méthode de décodage itératif selon la revendication 4, **caractérisée en ce que** la trace $tr(\mathbf{A}^4)$ est obtenue en calculant $tr(\mathbf{A}^4) = \sum_{i=0}^{K-1}\sum_{j=0}^{K-1}\sum_{k=0}^{K-1}\sum_{\ell=0}^{K-1} T_{ijk\ell}$ où :

$$T_{ijk\ell} = \sum_{\alpha \in \Omega_{ji}}\sum_{\beta \in \Omega_{kj}}\sum_{\gamma \in \Omega_{\ell k}} A_{\ell,i}\left(0,(\alpha + \beta + \gamma \bmod N)\right) A_{k,j}\left(0,\beta\right) A_{j,i}\left(0,\alpha\right) A_{\ell,k}\left(0,\gamma\right)$$

$A_{i,j}(\mu,v)$ étant l'élément à la ligne $\mu$ et la colonne $v$ de la matrice $\mathbf{A}_{i,j} = \mathbf{H}_i\mathbf{H}_j^T$, où $H_i$ et $H_j$ sont les matrices de parité élémentaires associées à deux polynômes de parité parmi les $K$ polynômes de parité sélectionnés à l'étape (b) et où $\Omega_{ji}$, $\Omega_{kj}$, $\Omega_{\ell k}$ sont les ensembles d'éléments non nuls des premières lignes respectives des matrices $\mathbf{A}_{i,j}$, $\mathbf{A}_{j,k}$, $\mathbf{A}_{k,\ell}$.

**7.** Méthode de décodage itératif selon l'une des revendications précédentes, **caractérisé en ce qu'**elle utilise un algorithme de type Min-Sum sur le graphe de Tanner associé à la matrice $H_{ext}$ générée à partir de la combinaison sélectionnée à l'étape (f).

8.   Méthode de décodage itératif selon l'une des revendications 1-6, **caractérisée en ce qu'**elle utilise un algorithme de type Sum-Product sur le graphe de Tanner associé à la matrice $\mathbf{H}_{ext}$ générée à partir de la combinaison sélectionnée à l'étape (f).

9.   Méthode de décodage itératif selon l'une des revendications précédentes, **caractérisée en ce que** l'on applique un critère de convergence aux valeurs des noeuds de variables du graphe de Tanner après un nombre prédéterminée d'itérations et si ce critère n'est pas satisfait, on conclut à une absence de la séquence LFSR.


**Patentansprüche**

1.   Verfahren zur iterativen Dekodierung im Durchlauf von Nachrichten einer LFSR-Sequenz der Länge $N$, die mittels eines Erzeugenden-Polynoms erzeugt wird, wobei die LFSR-Sequenz als Simplexcode einer Paritätsmatrix $\mathbf{H}$ zugeordnet ist, wobei das Dekodierverfahren die folgenden Schritte umfasst:

   (a) Bestimmen (410) einer Gruppe von Paritätspolynomen mit einem Gewicht gleich 3 und einer Konstante gleich 1 entsprechend einer Kombination von Paritätsgleichungen der Matrix $\mathbf{H}$ ;
   (b) Erzeugen (440) einer erweiterten Paritätsmatrix $\mathbf{H}_{ext}$ durch Verknüpfen einer vorbestimmten Zahl $K$ von Elementarparitätsmatrizen, die jeweils $K$ Paritätspolynomen zugeordnet sind, die aus der Gruppe ausgewählt sind ;
   (c) Überprüfen (450), dass der der Matrix $\mathbf{H}_{ext}$ zugeordnete Tanner-Graph keinen Zyklus der Länge 4 umfasst, und in Abwesenheit eines solchen Zyklus,
   (d) Berechnen (460) der Zahl von Zyklen der Länge 6 in dem Tanner-Graph, und in dem Fall, in dem diese Zahl gleich $NK$ ist, Speichern der Kombination der im Schritt (b) ausgewählten Paritätspolynome in einer Tabelle (475) ;

   wobei die Schritte (b), (c), (d) für alle Kombinationen von $K$ Paritätspolynomen der Gruppe wiederholt werden ; und

   (e) Berechnen (480), für jede Kombination von Paritätspolynomen, die in der Tabelle gespeichert ist, der Zahl von Zyklen der Länge 8 in dem Tanner-Graph, der der Matrix $\mathbf{H}_{ext}$ zugeordnet ist ;
   (f) Auswählen (490) einer Komination von $K$ Paritätspolynomen entsprechend der kleinsten Zahl von Zyklen der Länge 8, die im Schritt (e) berechnet wird, zur Durchführung einer iterativen Decodierung im Durchlauf von Nachrichten der Sequenz in dem Tanner-Graph, der der Matrix $\mathbf{H}_{ext}$ zugeordnet ist, die ausgehend von der derart ausgewählten Kombination erzeugt ist.

2.   Verfahren zur iterativen Dekodierung nach Anspruch 1, **dadurch gekennzeichnet, dass** die Überprüfung im Schritt (c) eine Bestimmung umfasst, ob eine der folgenden Bedingungen $r_b\text{-}i_b=i_a$, $r_b\text{-}i_b=r_a$, $r_b\text{-}i_b=r_a\text{-}i_a$; $r_a\text{-}i_a=i_b$ für wenigstens ein beliebiges Paar von Paritätspolynomen $g_a(x)=1+x^{i_a}+x^{r_a}$ und $g_b(x)=1+x^{i_b}+x^{r_b}$ aus den $K$ Paritätspolynomen erfüllt ist, die im Schritt (b) ausgewählt sind, wobei die Abwesenheit eines Zyklus der Länge 4 in dem Tanner-Graph festgestellt wird, wenn keine der vorstehenden Bedingungen erfüllt ist.

3.   Verfahren zur iterativen Decodierung nach einem der vorhergehenden Ansprüche, **dadurch gekennzeichnet, dass** die Zahl von Zyklen der Länge 6 in dem Tanner-Graph, der der Matrix $\mathbf{H}_{ext}$ zugeordnet ist, erhalten wird ausgehend

   von $N_6 = \dfrac{1}{6}\left(tr(\mathbf{A}^3) - 3KN\left(\left(K^2+3K+1\right)-9\left(K+1\right)+2\right)\right)$ wobei $\mathbf{A} = \mathbf{H}_{ext}\mathbf{H}_{ext}^T$, und wobei $tr(.)$ die Spurfunktion ist.

4.   Verfahren zur iterativen Decodierung nach einem der vorhergehenden Ansprüche, **dadurch gekennzeichnet, dass** das Berechnen der Zahl von Zyklen der Länge 8 in dem Tanner-Graph, der der Matrix $\mathbf{H}_{ext}$ zugeordnet ist, die Berechnung von $tr(\mathbf{A}^4)\text{-}4(3K+1)tr(\mathbf{A}^3)$ umfasst, wobei $\mathbf{A} = \mathbf{H}_{ext}\mathbf{H}_{ext}^T$, und wobei $tr(.)$ die Spurfunktion ist.

5.   Verfahren zur iterativen Decodierung nach Anspruch 3 oder 4, **dadurch gekennzeichnet, dass** die Spur $tr(\mathbf{A}^3)$

erhalten wird durch Berechnen von $tr(\mathbf{A}^3) = \sum_{i=0}^{K-1} \sum_{j=0}^{K-1} \sum_{k=0}^{K-1} T_{ijk}$ wobei:

$$T_{ijk} = \sum_{\alpha \in \Omega_{ji}} \sum_{\beta \in \Omega_{kj}} A_{k,i}(0,\gamma) A_{k,j}(0,\beta) A_{j,i}(0,\alpha)$$

wobei $A_{i,j}(\mu,v)$ das Element in der Zeile $\mu$ und der Spalte $v$ der Matrix $\mathbf{A}_{i,j} = \mathbf{H}_i \mathbf{H}_j^T$ ist, wobei $\mathbf{H}_i$ und $\mathbf{H}_j$ die Elementarparitätsmatrizen sind, die zwei Paritätspolynomen aus den $K$ Paritätspolynomen zugeordnet sind, die im Schritt (b) ausgewählt sind, wobei $\Omega_{ji}$, $\Omega_{kj}$ die Gruppen von Elementen ungleich Null der ersten Zeile der Matrix $A_{i,j}$ beziehungsweise der ersten Zeile der Matrix $A_{j,k}$ sind, und wobei $\gamma = (\alpha + \beta)\mathrm{mod}.N$.

6. Verfahren zur iterativen Dekodierung nach Anspruch 4, **dadurch gekennzeichnet, dass** die Spur $tr(\mathbf{A}^4)$ erhalten wird durch Berechnen von $tr(\mathbf{A}^4) = \sum_{i=0}^{K-1} \sum_{j=0}^{K-1} \sum_{k=0}^{K-1} \sum_{\ell=0}^{K-1} T_{ijk\ell}$ , wobei:

$$T_{ijk\ell} = \sum_{\alpha \in \Omega_{ji}} \sum_{\beta \in \Omega_{kj}} \sum_{\gamma \in \Omega_{\ell k}} A_{\ell,i}(0,(\alpha + \beta + \gamma \bmod N)) A_{k,j}(0,\beta) A_{j,i}(0,\alpha) A_{\ell,k}(0,\gamma)$$

wobei $A_{i,j}(\mu,v)$ das Element in der Zeile $\mu$ und der Spalte $v$ der Matrix $\mathbf{A}_{i,j} = \mathbf{H}_i \mathbf{H}_j^T$ ist, wobei $\mathbf{H}_i$ und $\mathbf{H}_j$ die Elementarparitätsmatrizen sind, die zwei Paritätspolynomen aus den $K$ Paritätspolynomen zugeordnet sind, die im Schritt (b) ausgewählt sind, und wobei $\Omega_{ji}$, $\Omega_{kj}$, $\Omega_{\ell k}$ die Gruppen von Elementen ungleich Null der jeweiligen ersten Zeilen der Matrizen $\mathbf{A}_{i,j}$, $\mathbf{A}_{j,k}$, $\mathbf{A}_{k,\ell}$ sind.

7. Verfahren zur iterativen Dekodierung nach einem der vorhergehenden Ansprüche, **dadurch gekennzeichnet, dass** es einen Algorithmus von Typ Min-Sum bei dem Tanner-Graph verwendet, der der Matrix $\mathbf{H}_{ext}$ zugeordnet ist, die ausgehend von der im Schritt (f) ausgewählten Kombination erzeugt ist.

8. Verfahren zur iterativen Dekodierung nach einem der Ansprüche 1 bis 6, **dadurch gekennzeichnet, dass** es einen Algorithmus von Typ Sum-Product bei dem Tanner-Graph verwendet, der der Matrix $\mathbf{H}_{ext}$ zugeordnet ist, die ausgehend von der im Schritt (f) ausgewählten Kombination erzeugt ist.

9. Verfahren zur iterativen Dekodierung nach einem der vorhergehenden Ansprüche, **dadurch gekennzeichnet, dass** man nach einer vorbestimmten Zahl von Iterationen ein Konvergenzkriterium auf die Werte der Knoten von Variablen des Tanner-Graphen anwendet, und wenn dieses Kriterium nicht erfüllt ist, man auf eine Abwesenheit der LFSR-Sequenz schließt.

**Claims**

1. A message-passing iterative decoding method of an LFSR sequence with a length $N$ generated by means of a generator polynomial, said LFSR sequence being associated, as a simplex code, with a parity matrix, **H,** said decoding method comprising the following steps of:

   (a) determining (410) a set of parity polynomials, with a weight equal to 3 and a constant equal to 1, corresponding to a combination of parity equations of the matrix **H;**
   (b) generating (440) an extended parity matrix $\mathbf{H}_{ext}$ by concatenating a predetermined number $K$ or elementary parity matrices, respectively associated with $K$ parity polynomials selected from said set;
   (c) checking (450) that the Tanner graph associated with the matrix $\mathbf{H}_{ext}$ does not include a cycle with a length 4 and, in the absence of such a cycle,
   (d) calculating (460) the number of cycles with a length 6 within the Tanner graph and, in the case where this number is equal to *NK,* storing in a table (475) the combination of parity polynomials selected in step (b);

steps (b), (c), (d) being repeated for all the combinations of *K* parity polynomials of said set; and

(e) calculating (480) for each combination of parity polynomials stored in said table the number of cycles with the length 8 in the Tanner graph associated with the matrix $\mathbf{H}_{ext}$
(f) selecting (490) a combination of *K* parity polynomials corresponding to the lowest number of cycles with a length 8 calculated in step (e) to carry out a message-passing iterative decoding of said sequence in the Tanner graph associated with the matrix $\mathbf{H}_{ext}$ generated from the combination thus selected.

2. The iterative decoding method according to claim 1, **characterized in that** checking in step (c) consists in determining whether one of the following conditions $r_b\text{-}i_b = i_a$ , $r_b\text{-}i_b = r_a$, $r_b\text{-}i_b = r_a\text{-}i_a$ ; $r_a\text{-}i_a = i_b$ is met for at least any one couple of parity polynomials $g_a(x)=1+x^{i_a}+x^{r_a}$ and $g_b(x)=1+x^{i_b}+x^{r_b}$, from the *K* parity polynomials selected in step (b), the absence of a cycle with a length 4 in the Tanner graph being set if none of the previous conditions is met.

3. The iterative decoding method according to one of the preceding claims, **characterized in that** the number of cycles with a length 6 in the Tanner graph associated with the matrix $\mathbf{H}_{ext}$ is obtained from

$$N_6 = \frac{1}{6}\left(tr(\mathbf{A}^3) - 3KN\left(\left(K^2 + 3K + 1\right) - 9\left(K + 1\right) + 2\right)\right) \text{ where } \mathbf{A} = \mathbf{H}_{ext}\mathbf{H}_{ext}^T \text{ and } tr(.) \text{ is the trace function.}$$

4. The iterative decoding method according to one of the preceding claims, **characterized in that** calculating the number of cycles with a length 8 in the Tanner graph associated with the matrix $\mathbf{H}_{ext}$ comprises calculating $tr(\mathbf{A}^4)$-$4(3K+1)tr(\mathbf{A}^3)$ where $\mathbf{A} = \mathbf{H}_{ext}\mathbf{H}_{ext}^T$ and $tr(.)$ is the trace function.

5. The iterative decoding method according to claim 3 or 4, **characterized in that** the trace $tr(\mathbf{A}^3)$ is obtained by calculating $tr(\mathbf{A}^3) = \sum_{i=0}^{K-1}\sum_{j=0}^{K-1}\sum_{k=0}^{K-1} T_{ijk}$ where:

$$T_{ijk} = \sum_{\alpha \in \Omega_{ji}} \sum_{\beta \in \Omega_{kj}} A_{k,i}\left(0,\gamma\right)A_{k,j}\left(0,\beta\right)A_{j,i}\left(0,\alpha\right)$$

$A_{i,j}(\mu,\nu)$ being the element at the row $\mu$ and the column $\nu$ of the matrix $\mathbf{A}_{i,j} = \mathbf{H}_i\mathbf{H}_j^T$ , where $\mathbf{H}_i$ and $\mathbf{H}_j$ are the elementary parity matrices associated with two parity polynomials from the *K* parity polynomials selected in step (b), where $\Omega_{ji}, \Omega_{kj}$ are the sets of non-zero elements of the first row of the matrix $\mathbf{A}_{i,j}$ and the first row of the matrix $\mathbf{A}_{j,k}$, respectively, and where $\gamma = (\alpha + \beta)\text{mod}.N$.

6. The iterative decoding method according to claim 4, **characterized in that** the trace $tr(\mathbf{A}^4)$ is obtained by calculating

$$tr(\mathbf{A}^4) = \sum_{i=0}^{K-1}\sum_{j=0}^{K-1}\sum_{k=0}^{K-1}\sum_{\ell=0}^{K-1} T_{ijk\ell} \text{ where:}$$

$$T_{ijk\ell} = \sum_{\alpha \in \Omega_{ji}} \sum_{\beta \in \Omega_{kj}} \sum_{\gamma \in \Omega_{\ell k}} A_{\ell,i}\left(0,\left(\alpha + \beta + \gamma \bmod N\right)\right) A_{k,j}\left(0,\beta\right) A_{j,i}\left(0,\alpha\right) A_{\ell,k}\left(0,\gamma\right)$$

$A_{i,j}(\mu,\nu)$ being the element at the row $\mu$ and the column $\nu$ of the matrix $\mathbf{A}_{i,j} = \mathbf{H}_i\mathbf{H}_j^T$ , where $\mathbf{H}_i$ and $\mathbf{H}_j$ are the elementary parity matrices associated with two parity polynomials from the *K* parity polynomials selected in step (b) and where $\Omega_{ji}, \Omega_{kj}, \Omega_{lk}$ are the sets of non-zero elements of the first respective rows of the matrices $\mathbf{A}_{i,j} \mathbf{A}_{j,k}, \mathbf{A}_{k,\ell}$.

7. The iterative decoding method according to one of the preceding claims, **characterized in that** a Min-Sum-type algorithm is used on the Tanner graph associated with the matrix $\mathbf{H}_{ext}$ generated from the combination selected in step (f).

8. The iterative decoding method according to one of claims 1 to 6, **characterized in that** it uses a Sum-Product-type algorithm on the Tanner graph associated with the matrix $\mathbf{H}_{ext}$ generated from the combination selected in step (f).

9. The iterative decoding method according to one of the preceding claims, **characterized in that** a criterion of convergence to the values of the nodes of the variables of the Tanner graph is applied after a predetermined number of iterations and if this criterion is not met, it is concluded that there is an absence of the LFSR sequence.

Fig. 1

Fig. 2

$F_a(k - i_a)$

$x(k)$

$F_a(k - r_a)$

$F_a(k)$

$x(k + i_a - r_a)$

$F_a(k - r_a + i_a)$

$x(k + i_a)$

$F_a(k - 2r_a + i_a)$

$F_a(k + i_a)$

Fig. 3

Détermination de l'ensemble $S_3$ des polynômes de parité de poids 3 à partir des combinaisons d'équations de parité de la matrice **H** — 410

Toutes les combinaisons de K polynômes dans $S_3$ sélectionnées ? — 420

Y

N

Sélection d'une nouvelle combinaison de K polynômes dans $S_3$

$$g_{a(k)}(x) \quad k = 1, ..., K$$

— 430

Obtention des matrices de parité $\mathbf{H}_{a(k)}$
Construction de la matrice de parité étendue $\mathbf{H}_{ext}$ — 440

Le graphe bipartite contient-il un cycle de longueur 4 ? — 450

Y

N

Calcul de $N_6$ — 460

$N_6$=NK? — 470

N

Y

Stockage de la combinaison de polynômes dans la table $\Omega$ — 475

480 — Calcul de $N_8$ pour toutes les combinaisons de polynômes stockées dans $\Omega$

490 — Sélection de la combinaison de polynômes de $\Omega$ réalisant $N_8^{min}$

_Fig. 4_

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20020116677 A

**Littérature non-brevet citée dans la description**

- **O.W. YEUNG et al.** An iterative algorithm and low complexity hardware architecture for fast acquisition of long PN codes in UWB systems. *Journal of VLSI Signal Processing,* 2006, vol. 43, 25-42
- **KSCHICHANG et al.** Factor graph and the sum-product algorithm. *IEEE Trans. on Information Theory,* Février 2001, vol. 47 (2
- Codes and decoding on general graphs. **N. WIBERG.** University of Linköping. 1996
- **F. PRINCIPE et al.** Rapid acquisition of Gold codes and related sequences using iterative message passing on redundant graphical models. *Proc. Milcom 2006,* 10 Janvier 2006, 1-7
- **M. DES NOES et al.** Improving the decoding of M-sequences by exploiting their decimation property. *Proc. EUSIPCO 2013,* 09 Septembre 2013, 1-5
- **M. DES NOES et al.** Blind identification of the uplink scrambling code index of a WCDMA transmission and application to femtocell networks. *Proc. IEEE ICC 2013,* 09 Juin 2013, 4530-4535
- Computation of low-weight parity checks for correlation attacks on stream ciphers. **W.T. PENZHORN et al.** Cryptography and Coding. Springer, 1995
- Fast correlation attacks: an algorithmic point of view. **P. CHOSE et al.** Advances in Cryptology, Eurocrypt 2002. Springer, 2002
- **T. R. HALFORD et al.** An algorithm for counting short cycles in bipartite graphs. *IEEE Trans. on Information Theory,* Janvier 2006, vol. 52 (1), 287-292